(19) Europäisches Patentamt / European Patent Office / Office européen des brevets

(11) **EP 4 645 465 A1**

(12) **EUROPEAN PATENT APPLICATION**
published in accordance with Art. 153(4) EPC

(43) Date of publication:
**05.11.2025 Bulletin 2025/45**

(21) Application number: **23911426.7**

(22) Date of filing: **15.11.2023**

(51) International Patent Classification (IPC):
$H01M\ 4/38$ (2006.01)    $C01B\ 32/05$ (2017.01)
$C01B\ 33/029$ (2006.01)    $H01M\ 4/36$ (2006.01)

(52) Cooperative Patent Classification (CPC):
C01B 32/05; C01B 33/029; H01M 4/36; H01M 4/38;
Y02E 60/10

(86) International application number:
**PCT/JP2023/041101**

(87) International publication number:
**WO 2024/142644 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2022 JP 2022212700**

(71) Applicant: **Group14 Technologies, Inc.
Woodinville, WA 98072 (US)**

(72) Inventors:
• **ITO, Yuji
Tokyo 105-7325 (JP)**
• **KURITA, Takayuki
Tokyo 105-7325 (JP)**
• **FUJITA, Masato
Tokyo 105-7325 (JP)**
• **TONEGAWA, Akihisa
Tokyo 105-7325 (JP)**
• **INOUE, Hirofumi
Tokyo 105-7325 (JP)**

(74) Representative: **Ostertag & Partner Patentanwälte mbB
Azenbergstraße 35
70174 Stuttgart (DE)**

(54) **COMPOSITE PARTICLES, METHOD FOR PRODUCING SAME AND USE OF SAME**

(57) The present invention provides composite particles consisting of a Si-C composite material capable of achieving a reduction in volume expansion of an electrode during charging in a lithium-ion rechargeable battery. The present invention includes composite particles including a carbon material and silicon, wherein a true density (He true density) by dry density measurement using helium gas is 1.30 g/cm³ or more and 2.00 g/cm³ or less, a true density (BA true density) by wet density measurement using 1-butanol is 1.00 g/cm³ or more and 1.64 g/cm³ or less, and the He true density is greater than the BA true density.

[FIG. 1]

Regulus 1.0kV x1.00k LA100(U)        50.0μm

**Description**

**Technical Field**

The present invention relates to composite particles, a method for producing such, and use of such.

**Background Art**

Lithium-ion rechargeable batteries used in IT devices such as smartphones and tablet PCs, vacuum cleaners, power tools, electric bicycles, drones, and automobiles require negative electrode active materials that combine high capacity and high output. Silicon (theoretical specific capacity: 4,200 mAh/g) having a higher theoretical specific capacity than currently used graphite (theoretical specific capacity: 372 mAh/g) has attracted attention as a negative electrode active material.

However, silicon (Si) expands and contracts in response to electrochemical lithium insertion and desorption, and the volume at the time of expansion is up to about 3 to 4 times the volume at the time of contraction. As a result, silicon particles self-destruct and detach from the electrode, and thus lithium-ion rechargeable batteries using silicon are known to have remarkably low cycle characteristics. Therefore, extensive research is currently underway on not only use of silicon as a replacement for graphite, but also on use as a negative electrode active material with reduced structural expansion and contraction as a whole. Among this research, many attempts have been made to form composites with carbonaceous materials.

As an example of a negative electrode active material having a high capacity and long life, patent document 1 discloses a silicon-carbon composite (Si-C composite material) obtained by a method for producing silicon in the pores of a porous carbon material by bringing a porous carbon material and silane gas into contact at a high temperature. The porous carbon material taught in patent document 1 has pores of 5 to 1,000 nm and is reacted with silane gas to fill the pores with silicon.

**Prior Art Literature**

**Patent Documents**

Patent Document 1: JP 2018-534720 A (Translation of PCT Application)

**Summary of Invention**

**Problem to Be Solved by Invention**

In the porous carbon material taught in patent document 1, there is a problem in that the Si-C composite material cannot achieve a reduction in volume expansion of an electrode during charging in lithium-ion rechargeable batteries due to small pore size, the pores being filled with silicon during silicon filling, and the like.

Therefore, an object of the present invention is to provide composite particles consisting of a Si-C composite material capable of achieving a reduction in volume expansion of electrodes during charging in a lithium-ion rechargeable battery.

**Means for Solving Problem**

The present invention has, for example, the following aspects.

[1] Composite particles including a carbon material and silicon, wherein

a He true density, which is the true density by dry density measurement using helium gas, is 1.30 g/cm$^3$ or more and 2.10 g/cm$^3$ or less,
a BA true density, which is the true density by wet density measurement using 1-butanol, is 1.00 g/cm$^3$ or more and 1.64 g/cm$^3$ or less, and
the He true density is greater than the BA true density.

[2] The composite particles according to [1], further including cavities having a diameter of 0.2 $\mu$m or more and 20 $\mu$m or less as observed in a cross-section thereof.
[3] The composite particles according to [1] or [2], wherein, in a Raman spectrum, a peak is present in at 450 cm$^{-1}$ or

more and 495 cm$^{-1}$ or less.

[4] The composite particles according to [3], wherein,

in a Raman spectrum, when an intensity of the peak is denoted $I_{Si}$ and an intensity of a G band (peak intensity close to 1,580 cm$^{-1}$) is denoted $I_G$, $I_{Si}/I_G$ is 1.3 or less.

[5] The composite particles according to [4], wherein, in a Raman spectrum, when an intensity of a D band (peak intensity close to 1,350 cm$^{-1}$) is $I_D$, $I_D/I_G$ is 0.2 or more and 1.4 or less.

[6] The composite particles according to any of [1] to [5], wherein the carbon material is porous carbon and silicon is present in the pores of the porous carbon.

[7] The composite particles according to any of [1] to [6], wherein a silicon content is 30 mass% or more and 80 mass% or less, and an oxygen content is 4.0 mass% or less.

[8] The composite particles according to any of [1] to [7], wherein (peak intensity of SiC (111) surface)/(peak intensity of Si (111) surface) is 0.01 or less in an XRD pattern by powder XRD using Cu-K$\alpha$ radiation.

[9] The composite particles according to any of [1] to [8], wherein a 50% particle diameter $D_{V50}$ in a cumulative particle size distribution on a volumetric basis is 1.0 $\mu$m or more and 40.0 $\mu$m or less, and a 90% particle diameter $D_{V90}$ is 50.0 $\mu$m or less.

[10] The composite particles according to any of [1] to [9], wherein a BET specific surface area is 0.5 m$^2$/g or more and 30.0 m$^2$/g or less.

[11] The composite particles according to any of [1] to [10], wherein, when atomic number ratios according to a narrow spectrum of Si, O, and C in X-ray photoelectron spectroscopy are denoted $A_{Si}$, $A_O$, and $A_C$, respectively, and ratios of SiO$_2$ and SiO from among Si type ratios according to Si 2p spectral state analysis are $B_{SiO2}$ and $B_{SiO}$, respectively, $A_{Si}$ is 0.05 or more, and $A_C/(A_c + A_{Si} \times (B_{SiO2} + B_{SiO}))$ is 0.55 or more.

[12] A method for producing composite particles, having a step (A) for bringing a gas including a silicon-containing gas into contact with a porous carbon satisfying the following conditions at 300°C or more and 500°C or less to precipitate silicon in the pores of the porous carbon.

Conditions: Cavities having a diameter of 0.2 $\mu$m or more and 20 $\mu$m or less as observed in a cross-section thereof are included and, in a nitrogen gas absorption test, when the pore volume when a relative pressure $P/P_0$ is 0.01 is denoted $V_{0.01}$, and a pore volume when the relative pressure $P/P_0$ is 0.99 is denoted $V_{0.99}$, $V_{0.99}$ is 0.4 cm$^3$/g or more and 1.5 cm$^3$/g or less, and $V_{0.01}/V_{0.99}$ is 0.4 or more.

[13] The method for producing composite particles according to [12], further having a step (B) for bringing a gas including a hydrocarbon having an unsaturated bond into contact with the particles obtained in the step (A) at 500°C or lower.

[14] The method for producing composite particles according to [12] or [13], further having a step (C) for oxidizing the particles obtained in the step (A).

[15] The method for producing composite particles according to [13], further having a step (C) for oxidizing the particles obtained in the step (B).

[16] The method for producing composite particles according to any of [12] to [15], wherein the composite particles according to any of [1] to [11] are produced.

[17] A negative electrode active material including the composite particles according to any of [1] to [11].

[18] A negative electrode composite layer including the negative electrode active material according to [17].

[19] A lithium-ion rechargeable battery including the negative electrode composite layer according to [18].

### Effect of Invention

According to the present invention, it is possible to achieve a reduction in volume expansion of an electrode during charging in a lithium-ion rechargeable battery.

### Brief Description of Drawings

[FIG. 1] A cross-sectional scanning electron microscope image of composite particles of Example 1.

[FIG. 2] A scanning electron microscope image of the composite particles of Example 1.

[FIG. 3] A scanning electron microscope image of the composite particles of Example 1.

[FIG. 4] A cross-sectional scanning electron microscope image of the composite particles of Example 1.

[FIG. 5] A silicon distribution image of the same particles as in FIG. 4 as observed by cross-sectional scanning electron microscopy with energy dispersive X-ray spectrometer (SEM-EDS).

**Embodiments of Invention**

Next, the present invention will be specifically described. Unless otherwise specified, a "lithium-ion rechargeable battery" may be referred to simply as a "battery."

[1] Composite particles

The composite particles according to the present invention are composite particles including a carbon material and silicon.

The composite particles may have a layer including carbon on the surface (hereinafter also referred to as a "coat layer including carbon" or "coat layer"). That is, the composite particles may be particulate matter (hereinafter also referred to as "coated composite particles") having a coat layer including carbon on the surface and having a particulate matter including a carbon material and silicon on the inside of the coat layer (hereinafter also referred to as "Si/C particles").

In the present invention, the Si/C particles and the coated composite particles may be referred to collectively as "composite particles" without distinction.

The "composite particles including a carbon material and silicon" are particulate matter including silicon (Si) on the surface and inside of the carbon material. The carbon material is preferably porous carbon, and the silicon is preferably included in at least the pores of the porous carbon. "Porous carbon" is a carbon material having pores.

In the composite particles, it is preferable that a fine Si domain be formed uniformly inside the carbon material. "Si domain" refers to a region where silicon is present. Due to the composite particles having this structure, expansion and contraction associated with charging and discharging occurs isotropically, and thus charge and discharge cycle durability is improved. This structure may be determined by performing cross-sectional SEM-EDS observation of the composite particles using a scanning electron microscope (Scanning Electron Microscope: SEM) and an energy dispersive X-ray spectroscope (Energy Dispersive X-ray Spectroscopy: EDS). When, inside the composite particles, distributions of silicon and carbon overlap, a fine Si domain at or below the spatial resolution of the SEM-EDS is understood to be dispersed uniformly.

The composite particles may be obtained by bringing a silicon source such as, for example silane ($SiH_4$) into contact with the particulate porous carbon to precipitate silicon (usually amorphous) in the pores within the porous carbon and optionally forming a further coat layer. At this time, by using porous carbon having fine pores, a fine Si domain may be formed uniformly within the particles.

The He true density, which is a true density as calculated by dry density measurement using helium gas, of the composite particles is 1.30 $g/cm^3$ or more.

When the He true density is less than 1.30 $g/cm^3$, it means that the coat layer is a thick layer of low-density organic material such as a tar component or polymer, that there is an excess of silicon precipitating on the surface of the composite particles, and the like.

When the He true density is 1.30 $g/cm^3$ or more, it indicates that the pores of the carbon material in the composite particles are sufficiently filled with silicon and that the coat layer is thin. When the He true density is 1.30 $g/cm^3$ or more, a specific capacity per unit volume of the composite particles may be increased, and a resistance may be lowered. From the same perspective, the He true density is preferably 1.60 $g/cm^3$ or more, and is more preferably 1.70 $g/cm^3$ or more.

The He true density of the composite particles is 2.10 $g/cm^3$ or less. When the He true density is 2.10 $g/cm^3$ or less, it indicates that the carbon material in the composite particles is amorphous, that the structure of the carbon material is more isotropic, and that there is little silicon carbide included in the composite particles. Silicon carbide has a higher density than carbon or Si, so the true density increases when silicon carbide is included in the composite particles. Silicon carbide is generated during production at high temperatures above 500°C, as described below.

Moreover, since the document value densities of the carbon and silicon are 2.26 $g/cm^3$ and 2.33 $g/cm^3$, respectively, when the He true density is 2.10 $g/cm^3$ or less, it is thought that there are pores in the composite particles that cannot be penetrated by helium gas from outside the particles. Therefore, because an effect of relieving stress of expansion and contraction during charging and discharging can be expected, cycle characteristics may be increased when the He true density is within the above range.

From the same perspective, it is preferable that the He true density be 2.00 $g/cm^3$ or less.

The true density by dry density measurement may be measured by a vapor phase replacement method. A vapor phase replacement method is a method in which a sample and helium gas are placed in a container in which the volume has been measured in advance by helium gas in an environment maintained at a constant temperature, and a true density is calculated from a volume of the helium gas that the sample has pushed out, as well as the mass of the sample. As a device for the vapor phase replacement method, for example, the AccuPyc (registered trademark) II 1340 Gas Pycnometer manufactured by Micromeritics may be used.

The BA true density, which is a true density calculated by wet density measurement using 1-butanol, of the composite particles is 1.00 $g/cm^3$ or more. If the BA true density is less than 1.00 $g/cm^3$, the specific capacity per unit volume of the composite particles is low, and thus the energy density is low. If the BA true density is 1.00 g/cm$^3$ or more, the specific capacity per unit volume of the composite particles is high, and thus the energy density is high. In view of the above, the BA true density is preferably 1.20 g/cm$^3$ or more, and is more preferably 1.30 g/cm$^3$ or more.

In the composite particles, He true density is greater than BA true density. 1-butanol has a larger molecular size than helium, and thus composite particles having He true density greater than BA true density includes closed pores that can be penetrated by helium but cannot be penetrated by 1-butanol. For composite particles that do not contain closed pores, the He true density and the BA true density are equal. Therefore, by combining the He true density and the BA true density, it may be estimated whether the composite particles have a hollow structure including closed pores.

The BA true density of the composite particles is 1.64 g/cm$^3$ or less. In composite particles having He true density greater than BA true density, composite particles having an He true density within the above range and a BA true density of 1.64 g/cm$^3$ or less are thought to have a hollow structure including closed pores inside. In composite particles having He true density greater than BA true density, composite particles having an He true density within the above range and a BA true density greater than 1.64 g/cm$^3$ are thought to have a structure having fewer closed pores than the hollow structure.

In view of the above, the BA true density is preferably 1.60 g/cm$^3$ or less, and is more preferably 1.50 g/cm$^3$ or less.

The true density by wet density measurement may be measured by a liquid phase replacement method. Liquid phase replacement is a method in which a sample and a liquid are placed in a container in which the volume has been measured in advance, and a true density is calculated from a volume of the liquid that the sample has pushed out, as well as the mass of the sample. Generally, ethanol, 1-butanol, isopropyl alcohol, and the like may be used as the liquid. The composite particles are defined by the true density, as measured by wet density measurement using 1-butanol for the liquid. As a wet density measuring device, for example, the Auto True Denser MAT-7000 manufactured by Seishin Enterprise may be used.

The details of the mechanism are unclear, but since the composite particles are thought to have a hollow structure, it is expected that the stress-relieving capability of volume expansion during charging will be increased, and it is presumed that, as a result, reduction of volume expansion of the electrode during charging may be achieved.

The He true density and the BA true density may be increased or decreased by adjusting the type, concentration, and ratio of emulsifiers, dispersants, and catalysts, as well as the resin concentration in the method for producing composite particles described below.

The composite particles preferably include cavities having a diameter of 0.2 μm or more and 20 μm or less as observed in cross-sectional observation. When the composite particles include the cavities, the stress-relieving capability of volume expansion during charging may be further improved. Since the stress of volume expansion during charging may be more dispersed, it is preferable that the composite particles have a plurality of the cavities. For example, by cross-sectional SEM observation of the composite particles, it may be confirmed whether the composite particles have a plurality of cavities.

The diameter is defined, for example, by observing a cross section of the composite particles under the conditions adopted in an example described below using a scanning electron microscope (SEM).

The cavity diameter of the cavities may be increased or decreased, for example, by changing the type, concentration, and ratio of emulsifiers, dispersants, and catalysts, as well as by adjusting the resin concentration in the method for producing composite particles described below.

In a Raman spectrum of the composite particles, there is usually at least a peak at a Raman shift of 450 to 495 cm$^{-1}$, close to 1,350 cm$^{-1}$, and close to 1,580 cm$^{-1}$. Usually, crystalline silicon such as silicon wafers, particulate silicon, and heat-treated SiO$_x$ has a peak close to 520 cm$^{-1}$. Amorphous silicon has a peak at a lower Raman shift than this, indicating that the composite particles have amorphous silicon when a peak is present at 450 to 495 cm$^{-1}$. When silicon is in an amorphous state, expansion and contraction during charging and discharging are relatively isotropic, and thus cycle characteristics may be increased.

When a peak intensity at 450 to 495 cm$^{-1}$ is denoted $I_{Si}$ and an intensity of the G band (peak intensity close to 1,580 cm$^{-1}$) is denoted $I_G$, the ratio $I_{Si}/I_G$ is preferably 1.3 or less, more preferably 0.94 or less, further preferably 0.64 or less, and most preferably 0.54 or less.

The appearance of a silicon peak in a Raman spectrum indicates the presence of silicon on the surface of the composite particles and/or in pores close to the surface of the composite particles. In XPS, which will be described later, information from the surface of a substance to a depth of several nm may be obtained, but in Raman spectra, it is known that information of a depth of approximately 1 μm to submicrometers from the surface may be obtained in a carbon material (hereinafter, a position of information obtained in a Raman spectrum is also referred to as "close to surface").

An $I_{Si}/I_G$ of 1.3 or less of the composite particles indicates that the composite particles surface is not thickly covered by a component containing silicon, indicating a configuration containing silicon and carbon. On the other hand, when the percentage of silicon is very high, $I_{Si}/I_G$ becomes much larger than the above range. Due to $I_{Si}/I_G$ being within the above range, the surface of the composite particles also undergoes expansion and contraction to the same extent as the inside of the composite particles during charging and discharging, and the concentration of stress from expansion and contraction on the surface of the composite particles can be avoided, leading to an improvement in cycle characteristics.

The lower limit of $I_{Si}/I_G$ is preferably 0.01, and more preferably 0.02. When $I_{Si}/I_G$ is less than 0.01, the thickness of the coat layer increases, which becomes a factor for a rise in resistance.

Note that the "peak intensity" is defined as the height from the baseline to the peak vertex after baseline correction.

The value of $I_{Si}/I_G$ may, for example, be changed by adjusting the reaction conditions (gas composition ratio, gas flow rate, temperature program, reaction time, and the like) in step (A) of the method for producing composite particles described later.

The composite particles have an R value ($I_D/I_G$), which is a ratio of the intensity of the G band $I_G$ when the intensity of the D band in a Raman spectrum (peak intensity close to 1,350 cm$^{-1}$) is denoted $I_D$, preferably between 0.2 and 1.4. If the R value is 0.2 or higher, the negative electrode using the composite particles has sufficiently low reaction resistance, leading to an improvement in the Coulomb efficiency of the battery. On the other hand, an R value of 1.4 or lower means that the carbon material has few defects. Having an R value of 1.4 or lower reduces the internal resistance of the battery and improves the rate characteristics. From the same perspective, the R value is more preferably 0.45 or higher, and even more preferably 0.65 or higher. Moreover, the R value is more preferably 1.30 or lower, and even more preferably 1.20 or lower.

The silicon content of the composite particles is preferably 30 mass% or more. Here, the "silicon content" of the composite particles refers to the content of silicon elements as silicon in the silicon metal and compounds contained in the composite particles. When the silicon content is 30 mass% or more, the amount of silicon in the composite particles is sufficient, and the discharge capacity may be increased. From the same perspective, the silicon content is more preferably 35 mass% or more, and even more preferably 40 mass% or more.

The silicon content of the composite particles is preferably 80 mass% or less. At 80 mass% or less, the amount of silicon in the composite particles is not excessive, allowing carbon to absorb the volume changes due to expansion and contraction. From the same perspective, the silicon content is more preferably 75 mass% or less, and even more preferably 70 mass% or less.

The silicon content in the composite particles may be quantified by a well-known element analysis method. For example, quantification may be performed by performing fluorescent X-ray analysis measurements as well as analysis which utilizes methods such as the fundamental parameter method (FP method). Additionally, after burning the composite particles to remove carbon and completely dissolving the remaining ash in acid or alkali, quantification may be achieved by inductively coupled plasma optical emission spectrometry (ICP-AES).

An oxygen content of the composite particles is preferably 4.0 mass% or less. An oxygen content of 4.0 mass% or less means that when the composite particles are used as the negative electrode active material of a lithium-ion rechargeable battery, the irreversible capacity of the negative electrode may be reduced. From the same perspective, the oxygen content is more preferably 2.0 mass% or less, and even more preferably 1.0 mass% or less. The lower limit of the oxygen content is preferably 0.2 mass%.

The oxygen content in the composite particles may be measured, for example, by an oxygen-nitrogen simultaneous measurement device.

In the present invention, unless otherwise specified, the oxygen content of the composite particles refers to the oxygen content of those stored within two days after production or in a non-oxidizing atmosphere. When measurement cannot be performed within two days after production due to circumstances of the step, a value thereof may be considered equivalent to that within two days after production, for example, if stored in an inert atmosphere such as argon and measured at a later date. This is because when stored in an inert atmosphere, oxidation does not progress.

The oxygen content can be maintained within the aforementioned range, for example, by storing the composite particles in an inert atmosphere.

The composite particles preferably have a half-width of the peak of the Si (111) plane in the XRD pattern, as measured by powder X-ray diffraction (powder XRD) using Cu-Kα radiation, of 3.0° or more. A half-width of 3.0° or more means that the crystallite size of silicon in the composite particles is small, which leads to the suppression of silicon destruction during charging and discharging. From the same perspective, the half-width is preferably 4.0° or more, and more preferably 5.0° or more. Moreover, the half-width is preferably 10.0° or less, and more preferably 8.0° or less. Note that the peak of the Si (111) plane refers to the peak originating from Si, which appears close to 28° at 2θ. Moreover, the "peak intensity" when determining the half-width is defined as the height from the baseline to the peak vertex after baseline correction.

The half-width of the peak of the Si (111) plane can be increased, for example, by using a large porous carbon of $V_{0.01}/V_{0.99}$ in the method for producing composite particles described later.

The composite particles preferably have a (peak intensity of SiC (111) plane)/(peak intensity of Si (111) plane) of 0.01 or less in the XRD pattern as measured by powder X-ray diffraction (powder XRD) using Cu-Kα radiation. As a result, the composite particles contain no SiC (silicon carbide) or have an extremely low content of SiC, which improves the utilization rate of silicon as a battery active material and allows for a higher initial discharge capacity. Note that the (peak intensity of SiC (111) plane)/(peak intensity of Si (111) plane) is also expressed as $I_{SiC(111)}/I_{Si(111)}$. The lower limit of

$I_{SiC(111)}/I_{Si(111)}$ is 0.00, meaning that it is more preferable that no peak intensity of the SiC (111) plane is observed. Note that the peak of the SiC (111) plane is a peak originating from SiC, which appears close to 35° in 2θ. Moreover, the peak of the Si (111) plane is a peak originating from Si, which appears close to 28° in 2θ.

The (peak intensity of SiC (111) plane)/(peak intensity of Si (111) plane) can be reduced, for example, by lowering the reaction temperature in the method for producing composite particles described later.

It is preferable that the composite particles do not contain graphite therein. The presence of graphite inside the composite particles can be identified by the XRD pattern obtained from powder X-ray diffraction measurements (powder XRD) using Cu-Kα radiation. If there is a significant presence of graphite inside the composite particles, a sharp peak originating from graphite, which appears close to 26° in 2θ, can be observed. Although halos originating from carbon and silicon oxides are also observed in this vicinity at the same time, the intensity of these patterns is low, while graphite is observed as a very sharp peak with high intensity, so when the graphite peak is not observed, graphite is thought to not be substantially contained in the composite particles.

For example, by using hard carbon as a carbon material and producing composite materials without adding graphite, composite particles that do not substantially contain graphite may be produced.

It is preferable that the composite particles uniformly form fine Si domains within the particles. When graphite is contained inside the composite particles, the expansion and contraction during charge and discharge become uneven within the particles, and cycle characteristics decrease.

It is preferable that $D_{V50}$, which is the 50% particle diameter in the volume-based cumulative particle size distribution of the composite particles, be 1.0 μm or more. This is because having a $D_{V50}$ of 1.0 μm or more can reduce side reactions with an electrolyte. Furthermore, it is easy to prepare a slurry with excellent handling properties and suitable viscosity and density for coating, and it is also easy to increase the density when used as an electrode. From this perspective, $D_{V50}$ is more preferably 2.0 μm or more, even more preferably 3.0 μm or more, and most preferably 3.5 μm or more.

It is preferable that the $D_{V50}$ of the composite particles be 40.0 μm or less. Having $D_{V50}$ of 40.0 μm or less shortens the diffusion length of lithium in each particle, thus improving the rate characteristics of lithium-ion rechargeable batteries, and preventing streaking and abnormal unevenness when coating the current collector using the slurry. From this perspective, $D_{V50}$ is more preferably 20.0 μm or less, and even more preferably 15.0 μm or less.

It is preferable that the $D_{V90}$, which is the 90% particle diameter in the volume-based cumulative particle size distribution of the composite particles, be 50.0 μm or less. Having $D_{V90}$ of 50.0 μm or less shortens the diffusion length of lithium in each particle, thus improving the rate characteristics of lithium-ion rechargeable batteries, and preventing streaking and abnormal unevenness when coating the current collector using the slurry. From this perspective, $D_{V90}$ is more preferably 40.0 μm or less, even more preferably 30.0 μm or less, and most preferably 20.0 μm or less.

The cumulative particle size distribution based on these volume standards is measured, for example, by a laser diffraction particle size analyzer.

The composite particles preferably have a BET specific surface area of 0.5 m$^2$/g or more. Having a BET specific surface area of 0.5 m$^2$/g or more may suitably adjust the slurry viscosity during electrode fabrication, allowing for the production of good electrodes. From the same perspective, the BET specific surface area is more preferably 0.9 m$^2$/g or more.

The composite particles preferably have a BET specific surface area of 30.0 m$^2$/g or less. At 30.0 m$^2$/g or less, side reactions with the electrolyte can be reduced. From the same perspective, the BET specific surface area is more preferably 25.0 m$^2$/g or less.

The BET specific surface area is usually measured by a dedicated measuring device known in the relevant technical field, and is calculated from an adsorption isotherm using a BET method. Nitrogen is usually used as the adsorbed gas.

The composite particles have atomic number ratios of Si, O, and C based on narrow spectra from X-ray photoelectron spectroscopy (XPS) denoted $A_{Si}$, $A_O$, and $A_C$, respectively, and among Si-type ratios of Si 2p spectral state analysis, the ratios of SiO$_2$ and SiO are denoted $B_{SiO2}$ and $B_{SiO}$, and it is preferable that $A_{Si}$ be 0.05 or more and that $A_C/(A_C + A_{Si} \times (B_{SiO2} + B_{SiO}))$ be 0.55 or more.

Note that $A_{Si} + A_O + A_C = 1.00$.

XPS is a method for obtaining information about the types, amounts, and chemical bonding states of elements present on the surface of a material, and it is known that information can be obtained to a depth of several nm from the surface of the material.

<1> $A_{Si}$

Having an $A_{Si}$ of 0.05 or more means that if the composite particles have a coat layer on the particle surface, the coat layer is thin. When the coat layer is thin, the resistance of the composite particles is low. $A_{Si}$ is preferably 0.15 or more, and more preferably 0.25 or more. Since the analysis depth of XPS is very shallow, at several nm, an ability to observe Si to some extent means that the coat layer is extremely thin.

The coat layer has lower electronic conductivity compared to that of a carbon coat. The electrical resistance of the composite particles increases when the coat layer is too thick, and thus the layer must be thin.

$$<2>\ A_C / (A_C + A_{Si} \times (B_{SiO2} + B_{SiO}))$$

The value of $A_C/(A_C + A_{Si} \times (B_{SiO2} + B_{SiO}))$ is an indicator of the carbon concentration at a position of a depth several nm from the surface of the composite particles (the depth of spatial resolution in XPS). Si is thought to exist as oxides such as $SiO_2$ and SiO on the surface of the composite particles, and most of the surface of the composite particles is thought to be formed with carbon and silicon oxides such as $SiO_2$ and SiO. However, $A_C$ includes information about carbon in the composite particles not only on the surface but also at positions of a depth several nm from the surface, and as such, this index is not a reflection of the carbon concentration of the coat layer alone.

Having a large $A_C/(A_C + A_{Si} \times (B_{SiO2} + B_{SiO}))$ indicates a high carbon concentration on the surface of the composite particles. An oxidation suppression ability improves as this carbon concentration increases. In other words, the composite particles become less prone to oxidation.

Having an $A_C/(A_C + A_{Si} \times (B_{SiO2} + B_{SiO}))$ of 0.55 or higher means that the carbon concentration on the surface increases, as well as the oxidation suppression ability. Therefore, $A_C/(A_C + A_{Si} \times (B_{SiO2} + B_{SiO}))$ is preferably 0.55 or higher, more preferably 0.70 or higher, and even more preferably 0.80 or higher. Moreover, it is preferable that $A_C/(A_C + A_{Si} \times (B_{SiO2} + B_{SiO}))$ be 0.98 or lower. Exceeding 0.98 means that the silicon oxide on the surface is too low, indicating a low oxidation suppression ability.

The value of $A_C/(A_C + A_{Si} \times (B_{SiO2} + B_{SiO}))$ may be changed, for example, by adjusting the reaction temperature, reaction time, reaction pressure, or type or concentration of the hydrocarbon in step (B) in the method for producing composite particles described later.

When the composite particles have a coat layer, it is preferable that the coat layer contains a compound derived from a hydrocarbon. The presence of a compound derived from a hydrocarbon in the coat layer may be determined by performing thermal decomposition GC-MS measurements of the composite particles, as a compound derived from a hydrocarbon is included in the gas generated from the composite particles between 200°C and 600°C.

The coat layer may be produced by bringing Si/C particles into contact with a carbon source having unsaturated bonds at a low temperature and then oxidizing the obtained substance. Details will be described later.

In the coated composite particles, it is preferable that the coat layer be thin enough to be substantially unmeasurable by cross-sectional observation using an electron microscope. When the coat layer is thin, as described above, the composite particles have a low resistance. Scanning electron microscopes (SEM) do not have sufficient resolution to distinguish thicknesses of a few nm, and therefore cannot measure the thickness of coat layers thinner than that. Transmission electron microscopes (TEM) have sufficient resolution and can observe thicknesses of a few nm, but when preparing a sample for TEM observation of a thin film including a coat layer of composite particles, the coat layer of the composite particles is damaged and destroyed by processing, making it impossible to observe the thickness of the coat layers with TEM in practice. "Substantially unmeasurable" refers to such a state. However, even for a thin film that is substantially unmeasurable by cross-sectional observation using electron microscopy, the presence of the coat layer may be confirmed from the aforementioned XPS.

As mentioned above, it is preferable that the expansion and contraction during charging and discharging be uniform within the particles, so the shape of the composite particles is preferably such that the average aspect ratio is 1.25 or less, and it is more preferable that a portion of the particles have no corners. It is even more preferable that the composite particles be spherical (with a cross-section of the composite particles being circular). An aspect ratio is the value obtained by dividing the long diameter of the particle by the short diameter. An aspect ratio of 1.00 indicates that the long and short diameters are equal, so the closer the average aspect ratio is to 1.00, the more preferable it is.

A circularity may be determined by an average circularity calculated from the cross-sectional shape. An average circularity of 0.95 or more and 1.00 or less is preferable. Circularity is expressed by the following formula.

$$(\text{Circularity}) = 4\pi \times (S / L^2)$$

Here, S is the particle cross-sectional area $[m^2]$, and L is the particle perimeter [m].

The above average aspect ratio and average circularity can be calculated by analyzing images obtained from scanning electron microscopy (SEM) using image analysis software. The analysis is performed on 100 composite particles randomly selected from SEM photographs, and the average value (number average) of the 100 is used for determination. As image analysis software, for example, ImageJ is available.

The aspect ratio and average circularity may be adjusted by using porous carbon that meets the above conditions in the method for producing composite particles described later.

[2] Method for producing composite particles

The method for producing composite particles according to the present invention has the following step (A). By the method for producing composite particles of the present invention, it is possible to obtain the composite particles according to the present invention, that is, the composite particles described in [1].

Step (A): A step of bringing a gas including a silicon-containing gas into contact with a porous carbon satisfying the following conditions at 300°C or more and 500°C or less to precipitate silicon in the pores of the porous carbon Conditions: Cavities having a diameter of 0.2 $\mu$m or more and 20 $\mu$m or less as observed in a cross-section thereof are included and, in a nitrogen gas absorption test, when the pore volume when a relative pressure $P/P_0$ is 0.01 is denoted $V_{0.01}$, and a pore volume when the relative pressure $P/P_0$ is 0.99 is denoted $V_{0.99}$, $V_{0.99}$ is 0.4 cm$^3$/g or more and 1.5 cm$^3$/g or less, and $V_{0.01}/V_{0.99}$ is 0.4 or more.

A carbon material having pores is referred to as "porous carbon" in the present invention. Since it is preferable for composite particles to have a structure containing silicon within the particles, it is preferable for the porous carbon to have a pore volume that can carry silicon inside.

Since it is preferable for silicon to be included as fine domains within the composite particles, it is even more preferable for the porous carbon to have many fine pores. Specifically, $V_{0.01}/V_{0.99}$ is more preferably 0.45 or more, and most preferably 0.50 or more. The nitrogen gas adsorption test may be performed using a known method.

Therefore, the porous carbon preferably has a pore volume that allows for silicon to be carried therein, and has fine pores. Specifically, it is preferable that cavities having a diameter of 0.2 $\mu$m or more and 20 $\mu$m or less as observed in a cross-section thereof be included and, in a nitrogen gas absorption test, when the pore volume when a relative pressure $P/P_0$ is 0.01 is denoted $V_{0.01}$, and a pore volume when the relative pressure $P/P_0$ is 0.99 is denoted $V_{0.99}$, $V_{0.99}$ is 0.4 cm$^3$/g or more and 1.5 cm$^3$/g or less, and $V_{0.01}/V_{0.99}$ is 0.4 or more. When the porous carbon satisfies these conditions, the pores are not filled with silicon and the composite particles may have a hollow structure even during silicon filling. The porous carbon may or may not contain a component other than carbon within a range that does not hinder performance. It is preferable that 90 mass% or more of the porous carbon be carbon, and 95 mass% or more is more preferable.

The porous carbon may be produced by a conventionally known method. Examples include a method in which a hollow carbide is prepared by firing a phenolic resin having cavities inside and is activated as necessary, and a method in which a resin made to include a different material that gasifies during carbonization, such as polystyrene particles and methacrylic resin particles in a phenol resin, is fired to prepare a hollow carbide having the polystyrene particles and methacrylic resin particle portions as cavities and is activated as necessary. Crushing, pulverizing, or classification may also be performed as necessary.

Methods for synthesizing a phenol resin having cavities inside include a method for adjusting the type, concentration, and ratio of an emulsifier, dispersant, and catalyst, as well as the resin concentration when synthesizing the phenol resin using dispersion polymerization or precipitate polymerization in water.

It is preferable that the porous carbon be adjusted to a desired shape or particle size distribution of the composite particles before carrying out step (A). This is because the shape and particle size of the particles do not change much in step (A), and the shape and particle size distribution of the composite particles remain the same as those of the porous carbon. Therefore, the porous carbon used in step (A) may be crushed or pulverized and sieved.

The porous carbon is preferably spherical. Spherical porous carbon that has been carbonized and activated from spherical phenolic resin is more preferable. Moreover, spherical porous carbon that has not undergone a pulverizing step is even more preferable because the spherical shape can be maintained.

As the silicon-containing gas, silane gas may preferably be used. Silane gas may be used in a mixture with an inert gas such as helium or argon, or with a reducing gas such as hydrogen.

Step (A) involves placing the porous carbon in a reactor and bringing a silicon-containing gas into contact with the porous carbon to deposit silicon in the pores of the porous carbon, thereby obtaining composite particles (Si/C particles).

The form of the reactor is not limited. As a reactor, a furnace having a stirring function for powders such as a stationary furnace, a fluidized bed furnace, and a rotary kiln, as well as a continuous furnace such as roller hearth kiln and pusher furnace may be used.

The reaction temperature is not limited as long as a silicon-containing gas such as silane gas decomposes and deposits silicon in the pores of the porous carbon at the temperature, but is preferably between 300°C and 500°C. At temperatures below 300°C, the decomposition of silane gas does not occur sufficiently, resulting in inadequate silicon deposition. When the temperature exceeds 500°C, the decomposition of silane gas occurs within the pores of the porous carbon, and silicon deposition on the surface of the porous carbon (including the openings of the pores) becomes more pronounced than silicon deposition within the pores, leading to insufficient deposition inside the pores as the pore openings get blocked by the deposited silicon.

Even at temperatures of 500°C and below, the decomposition of silane occurs on the surface of the porous carbon, and silicon is deposited. In general, the surface area of the pores in porous carbon is much larger than the external surface area, resulting in a significantly greater amount of silicon being deposited within the pores of the porous carbon. It is preferable for silicon to be present within the pores rather than on the external surface of the porous carbon, as this enhances the durability of the composite particles against the stresses associated with the expansion and contraction of silicon during battery charge and discharge. At higher processing temperatures, deposition on the surface of the porous carbon becomes more pronounced, increasing the number of areas where the openings of the pores are blocked. As the deposition of silicon on the surface of the porous carbon is suppressed and the amount of silicon deposited within the pores of the porous carbon increases, a reaction temperature of 450°C or lower is preferable, and 420°C or lower is even more preferable.

Conditions such as gas composition ratio, gas flow rate, and temperature program are adjusted as appropriate while observing the properties of the composite particles. The method for producing the composite particles preferably includes the following step (B) in addition to the step (A).

Step (B): A step of bringing a gas including a hydrocarbon having an unsaturated bond into contact with the particles obtained in the step (A) at a temperature of 500°C or lower The particles obtained in step (B) are also referred to as coated composite particles.

Step (B) involves placing the Si/C particles obtained in step (A) in a reactor and bringing a gas including a hydrocarbon having an unsaturated bond into contact with the Si/C particles at a temperature of 500°C or lower. The coat layer of the coated composite particles is thin. Methods that deposit carbon on the surface, such as carbon CVD, are not suitable because they form thick carbon coatings. It is preferable to react the Si-H groups on the surface of the Si/C particles with a hydrocarbon containing an unsaturated bond to form a layer containing a hydrocarbon on the surface of the Si/C particles. The layer including this hydrocarbon may include a substance in which the hydrocarbon has reacted with each itself. As a gas of a hydrocarbon having an unsaturated bond, a gas of a hydrocarbon having a double or triple bond may be used. When the hydrocarbon is a compound that does not gasify at normal pressure due to low vapor pressure, the hydrocarbon may be used at a pressure lower than normal pressure. Preferable examples include acetylene, ethylene, propylene, and 1,3-butadiene, which are gases at normal pressure, with acetylene and ethylene being more preferable. At this time, it is acceptable to use a plurality of types of hydrocarbons. Moreover, an inert gas such as helium or argon, or a reducing gas such as hydrogen may be mixed and used.

In step (B), treatment at a low temperature of 500°C or lower is required to react the Si-H group with a hydrocarbon having an unsaturated bond. The reaction temperature in step (B) is preferably 420°C or below from the perspective of preventing the formation of silicon carbide, and more preferably 400°C or below. Moreover, from the perspective of not requiring a heating step and decreasing hydrogen generation due to the decomposition of Si-H groups, the reaction temperature in step (B) is preferably at or below the temperature of step (A). When the temperature exceeds 500°C, the amount of Si-H groups that decompose increases, making it difficult for the desired reaction, that is, the reaction between the Si-H groups on the surface of Si/C particles and the unsaturated bonds of hydrocarbons, to occur. Moreover, since the reactivity of silicon in Si/C particles is very high, at high temperatures exceeding 500°C, a reaction occurs between porous carbon and silicon, resulting in the generation of silicon carbide, which decreases the capacity of the composite particles.

There is no restriction on the lower limit of the reaction temperature as long as it is a temperature at which the hydrocarbon having an unsaturated bond reacts on the surface of Si/C particles, but since the reaction rate is low at low reaction temperatures, the temperature is preferably 100°C or higher, and more preferably 150°C or higher.

The thickness of the layer including the hydrocarbon may be a thickness corresponding to the molecular layer of the hydrocarbon, or may be a thickness corresponding to several molecular layers. Moreover, some of the hydrocarbon may be decomposed. Even when some of the hydrocarbon decomposes into carbon, the layer including the hydrocarbon is preferably a thin film because it is a material with a high resistance, unlike carbon coatings. Therefore, it is preferable that the weight change before and after step (B) be small. The increase in mass of coated composite particles having a layer including the hydrocarbon obtained in step (B) relative to the mass of Si/C particles before step (B) is more preferably 1.0 mass% or less, and even more preferably 0.5 mass% or less.

It is preferable that steps (A) and (B) be carried out continuously. The Si/C particles obtained in step (A) have a high reactivity of the surface silicon, so when exposed to the atmosphere, oxidation progresses, and the Si-H groups on the surface are reduced. Therefore, it is preferable that steps (A) and (B) be carried out continuously without exposure to the atmosphere (air). It is preferable to use the same equipment for steps (A) and (B) because it is easier to implement continuously. The time between steps (A) and (B) is not limited as long as the Si/C particles are not exposed to the atmosphere. For example, after step (A), step (B) may be performed after storing under an inert atmosphere. Moreover, when the Si/C particles obtained in step (A) do not come into contact with the atmosphere, different equipment may be used for steps (A) and (B).

The method for producing the composite particles preferably includes the following step (C) in addition to the steps (A) and (B).

Step (C): A step of oxidizing the particles obtained in step (A) (Si/C particles) or the particles obtained in step (B) (coated composite particles)

In a method for producing composite particles wherein step (C) is performed on the particles obtained in step (A) without performing step (B), there is the concern that oxidation may progress when the composite particles are stored in air because of the fact that a reaction does not ensue due to the hydrocarbon having an unsaturated bond, but the step is simpler.

In the coated composite particles obtained in step (B), this step (C) is a step of introducing oxygen into the coat layer (more precisely, the layer including a hydrocarbon formed on the surface of the composite particles in step (B)). Although the structure of the coat layer is not clear, the inclusion of oxygen in the coat layer improves the oxidation suppression ability and lowers resistance. Oxidation may be performed by bringing the coat layer into contact with a gas including oxygen (more specifically, an oxidizing gas). A gas including oxygen preferably has an oxygen concentration of 1 to 25 vol%, more preferably 1 to 20 vol%, and even more preferably 5 to 20 vol%. In that case, the oxygen is diluted using argon or nitrogen. Air may be used as a gas including oxygen, but to perform stable oxidation, it is preferable that the humidity of the air be adjusted and maintained.

It is preferable that heat treatment be performed in an inert atmosphere or under low pressure after bringing the coat layer into contact with the gas including oxygen. The temperature during heat treatment is preferably 400°C or below. By performing heat treatment at or below 400°C, it is believed that unreacted Si-H groups may be decomposed and converted into silicon, thereby stably implementing the oxygenic formation of a composite in the coat layer. The heat treatment time is, for example, 0.1 to 100 hours.

The reaction temperature of step (C) is preferably room temperature or above and 200°C or below. Exceeding 200°C is not preferable as it may cause decomposition of the coat layer or excessive oxidation of silicon.

The reaction time of step (C) is, for example, 0.1 to 120 hours.

In step (C), it is acceptable to change the oxygen concentration for oxidation treatment.

Different devices may be used in step (C) than are used in step (B). Moreover, it is acceptable to carry out steps (B) and (C) a plurality of times. Examples of methods include: performing step (C) followed by step (B), performing step (C) then performing step (B) and continuing to perform step (C), and the like. When performing step (C) followed by step (B), the "particles obtained in step (C)" correspond to the "particles obtained in step (A)" in step (B).

After producing composite particles through steps (A), (B), and (C), the particles may agglomerate. In that case, it is preferable that disintegration be performed, returning the particles to the shape and particle size distribution of the porous carbon raw material.

[3] Negative electrode active material

The negative electrode active material according to the present invention includes the composite particles according to the present invention. The composite particles may be used by mixing two or more types. The negative electrode active material may further include another component. Examples of other components include those generally used as a negative electrode active material of lithium-ion rechargeable batteries, for example, graphite, hard carbon, soft carbon, lithium titanate ($Li_4Ti_5O_{12}$), silicon, tin, other alloy-based active materials and composite materials thereof, and the like may be mentioned. These components are usually used in particle form. One type of a component other than the composite particles may be used, or two or more types may be used. Among these, graphite particles and hard carbon are particularly preferable.

When including another component to form the negative electrode active material, the content of the composite particles in the negative electrode active material is adjusted to usually be 1 to 50 mass%, and preferably 2 to 25 mass%. By mixing the other component, it is possible to create a negative electrode active material that maintains the excellent properties of the composite particles while also possessing the excellent properties of another carbon material. When using a plurality of types of materials as negative electrode active materials, such may be used after mixing in advance, or may be added sequentially when preparing the slurry for forming the negative electrode mixture, as described later.

As a device for mixing composite particles with other materials, commercially available mixers and stirrers may be used. Specific examples include mixers such as those for mortar, ribbon mixers, V-type mixers, W-type mixers, one-blade mixers, and Nauta mixers.

[4] Negative electrode composite layer

The negative electrode composite layer according to the present invention includes the negative electrode active material according to the present invention.

The negative electrode composite layer of the present invention may be used as a negative electrode composite layer for lithium-ion rechargeable batteries. The negative electrode composite layer generally consists of a negative electrode active material, a binder, and a conductivity aid as an optional component.

The method for producing the negative electrode composite layer may utilize a known method such as, for example, that illustrated below. Using the negative electrode active material, binder, conductivity aid as an optional component, and solvent, a slurry is prepared to form the negative electrode composite. The slurry is coated onto a current collector such as a copper foil and dried. This is further vacuum dried to remove the solvent. The obtained product may be referred to as a negative electrode sheet. The negative electrode sheet consists of the negative electrode composite layer and the current collector. The negative electrode sheet is cut or punched into a required shape and size, then pressed to improve the density of the electrode composite layer (which may be referred to as electrode density). An energy density of the battery increases when electrode density is improved. The pressing method is not particularly limited as long as the process can achieve a desired electrode density, but uniaxial pressing, roll pressing, and the like may be mentioned. The order of shape processing and pressing is not restricted. Pressing may be performed after shape processing, or shape processing may be performed after pressing. An electrode in a desired shape and electrode density is referred to as a negative electrode in the present invention. The negative electrode may also further include that which is in a state where a current collector is attached with a current collector tab as needed.

As a binder, any binder commonly used in the negative electrode composite layer of a lithium-ion rechargeable battery may be freely selected. Examples of binders include: polyethylene, polypropylene, ethylene-propylene terpolymer, butadiene rubber, styrenebutadiene rubber (SBR), butyl rubber, acrylic rubber, polyvinylidene fluoride (PVdF), polytetrafluoroethylene (PTFE), polyethylene oxide, polyepichlorohydrin, polyphosphazene, polyacrylonitrile, carboxymethyl cellulose (CMC) and salts thereof, polyacrylic acid, and polyacrylamide. One type of binder may be used, or two or more types may be used. The amount of binder is preferably 0.5 to 30 parts by mass relative to 100 parts by mass of the negative electrode material.

The conductivity aid is not particularly limited so long as it serves to impart electronic conductivity and dimensional stability (the ability to absorb volume changes due to the insertion and removal of lithium) to the electrode. Examples of conductivity aids include carbon nanotubes, carbon nanofibers, vapor-phase carbon fibers (for example, "VGCF (registered trademark)-H" produced by Showa Denko K.K.), conductive carbon black (for example, "Denka Black (registered trademark)" produced by Denka Co., Ltd., "SUPERC65" produced by Imerys Graphite & Carbon, and "SUPERC45" produced by Imerys Graphite & Carbon), and conductive graphite (for example, "KS6L" produced by Imerys Graphite & Carbon, and "SFG6L" produced by Imerys Graphite & Carbon). A plurality of types of these conductivity aids may be used.

The conductivity aid preferably includes carbon nanotubes, carbon nanofibers, or vapor-phase carbon fibers, and the fiber length of these conductivity aids is preferably at least 1/2 of the $D_{V50}$ of the composite particles. With this length, these conductivity aids serve as a bridge between the negative electrode active materials including the composite particles, improving cycle characteristics. Furthermore, single-wall type or multi-wall type carbon nanotubes with a fiber diameter of 15 nm or less are preferable from the perspective of increasing the number of bridges at the same amount of addition. Moreover, being more flexible, such is preferable from the perspective of improving electrode density.

The amount of the conductivity aid is preferably 1 to 30 parts by mass relative to 100 parts by mass of the negative electrode material.

There are no particular restrictions on the solvent used when preparing the slurry for electrode coating, and examples include N-methyl-2-pyrrolidone (NMP), dimethylformamide (DMF), isopropanol, tetrahydrofuran (THF), water, and the like. In the case of a binder using water as a solvent, it is also preferable that a thickener be used in combination. The amount of solvent may be adjusted to a viscosity that allows the slurry to easily coat the current collector.

[5] Lithium-ion rechargeable batteries

The lithium-ion rechargeable battery according to the present invention includes a negative electrode composite layer according to the present invention. The lithium-ion rechargeable battery usually includes a negative electrode consisting of the negative electrode composite layer and current collector, a positive electrode consisting of the positive electrode composite layer and current collector, at least one of a non-aqueous electrolyte and non-aqueous polymer electrolyte present therebetween, a separator, and a battery case that houses these components. The lithium-ion rechargeable battery may include the negative electrode composite layer, and another configuration may be adopted without particular limitation, including conventionally known configurations.

The positive electrode composite layer usually consists of a positive electrode active material, a conductivity aid, and a binder. A general configuration found in a usual lithium-ion rechargeable battery may be used for the positive electrode in the lithium-ion rechargeable battery.

As the positive electrode active material, there are no particular restrictions on material as long as the material allows for reversible electrochemical lithium insertion/extraction and has a standard oxidation reduction potential of these reactions sufficiently higher than that of the standard oxidation reduction potential of a negative electrode reaction. Examples of the positive electrode active material include: $LiCoO_2$, $LiNiO_2$, $LiMn_2O_4$, $LiCo_{1/3}Mn_{1/3}Ni_{1/3}O_2$, $LiCo_{0.6}Mn_{0.2}Ni_{0.2}O_2$, $LiCo_{0.8}Mn_{0.1}Ni_{0.1}O_2$, carbon-coated $LiFePO_4$, or suitable mixtures thereof.

A conductivity aid, binder, and solvent mentioned in the negative electrode composite layer section may be used for slurry preparation. Aluminum foil is preferably used as the current collector.

The non-aqueous electrolytic solution and the non-aqueous polymer electrolyte used in the lithium-ion rechargeable battery may be used as an electrolytic solution for a well-known lithium-ion rechargeable battery. For example, a solution is used in which a lithium salt such as $LiClO_4$, $LiPF_6$, $LiAsF_6$, $LiBF_4$, $LiSO_3CF_3$, or $CH_3SO_3Li$ is dissolved in a following solvent or polymer. Examples of solvents include: non-aqueous solvents such as ethylene carbonate, diethyl carbonate, dimethyl carbonate, ethyl methyl carbonate, propylene carbonate, butylene carbonate, acetonitrile, propioni-trile, dimethoxyethane, tetrahydrofuran, and $\gamma$-butyrolactone; gel-like polymers containing polyethylene oxide, polyacrylonitrile, polyvinylidene fluoride, and polymethyl methacrylate; and polymers having an ethylene oxide bond.

Moreover, a small amount of an additive commonly used in electrolytes for lithium-ion rechargeable batteries may be added to the non-aqueous electrolyte. Examples of such substances include vinylene carbonate (VC), biphenyl, propanesultone (PS), fluoroethylene carbonate (FEC), and ethylene sultone (ES). Preferable examples include VC and FEC. The amount of addition is preferably 0.01 to 20 mass% relative to 100 mass% of the non-aqueous electrolyte.

As a separator, any material that can be used in a typical lithium-ion rechargeable battery may be freely selected, including combinations thereof, such as microporous films made of polyethylene or polypropylene. Such separators may also have particles such as $SiO_2$ and $Al_2O_3$ mixed as fillers or adhered to the surface.

As a battery case, there are no particular restrictions as long as the positive and negative electrodes, separator, and electrolyte can be accommodated. In addition to commercially available battery packs, cylindrical cells of type 18650, coin-type cells, and other standardized forms in the industry, those packed in aluminum packaging may be freely designed and used.

Each electrode may be stacked and packed for use. Moreover, single cells may be connected in series and used as batteries and modules.

**Examples**

The present invention will be described in detail below by presenting an example and comparative example, but the present invention is not limited to these examples.

The measurement of physical properties and battery evaluation were conducted as follows.

[1] Measurement of physical properties

[1-1] Dry true density measurement

After vacuum drying a sample at 180°C for 12 hours, the sample was filled in the measurement cell to 40 to 60% under a dry argon atmosphere in a glove box, and the mass of the sample was measured after tapping the cell more than 100 times. The sample was then taken out into the atmosphere and, via the following method, dry density measurement was performed by the constant volume expansion method using helium gas, and an He true density was calculated.

    Device: Micromeritics AccuPyc (registered trademark) II 1340 Gas Pycnometer
    Measurement cell: Aluminum, depth 39.3 mm, inner diameter 18 mm
    Carrier gas: Helium gas
    Gas pressure: 19.5 psiG (134.4 kPaG)
    Number of purges during measurement: 200 times
    Temperature: 25°C $\pm$ 1°C

[1-2] Wet true density measurement

Wet density measurement was performed by the liquid phase replacement method using the following device, and the BA true density was calculated.

    Device: Seishin Enterprise Auto True Denser MAT-7000
    Measurement cell volume: approximately 40 cm$^3$
    Measurement sample volume: approximately 10 mL
    Wait time: 5 minutes
    Vacuum time: 30 minutes
    Liquid used: 1-butanol

[1-3-1] Negative electrode preparation

Composite particles and graphite were mixed to form a negative electrode active material so that a silicon concentration was 4 mass%. For the graphite, artificial graphite was used with a BET specific surface area = 2.7 $m^2$/g, DV10 = 7 $\mu$m, DV50 = 14 $\mu$m, DV90 = 27 $\mu$m, tap density = 0.98 g/$cm^3$, first charge (de-Li) specific capacity 360 mAh/g, and first Coulomb efficiency of 92%.

Mass ratio of negative electrode active materials: In order to achieve the ratio 96.4:0.5: 0.1:1.5:1.5, the following raw materials were prepared: conductive carbon black (SUPERC45 (registered trademark), made by Imerys Graphite & Carbon): single wall-type carbon nanotubes (length 5 $\mu$m): carboxymethylcellulose: styrene butadiene rubber, and these were dispersed in water while adjusting the concentration so as to be applied at the grammage described below, and kneaded in a planetary centrifugal mixer (made by THINKY CORPORATION) to obtain a slurry for forming a negative electrode composite layer.

The slurry for forming the negative electrode composite layer was uniformly applied on a 20 $\mu$m thick copper foil serving as a current collector foil using a 150 $\mu$m gap doctor blade, dried using a hot plate, and dried in vacuum at 70°C for 12 hours to form the negative electrode composite layer on the current collector foil. The grammage of the negative electrode composite layer after drying was adjusted to 13 mg/$cm^2$. A negative electrode was obtained by roll pressing at a density of 1.6 g/$cm^3$. This thickness was measured using a micrometer and set as an electrode thickness. The difference between the thickness of the current collecting foil which was used and the electrode thickness was set as the initial electrode composite layer thickness.

[1-3-2] Positive electrode preparation

NMC811 was used as the positive electrode active material. Positive electrode active materials: Conductive carbon black (TIMCAL SUPER C65): polyvinylidene fluoride were set to a mass ratio of 96.5:1.5:2.0, the concentration was adjusted with N-methylpyrrolidone to allow coating to be carried out at the grammage described below, and this was kneaded in a planetary centrifugal mixer (manufactured by THINKY CORPORATION) to obtain a slurry for forming a positive electrode composite layer.

The slurry for forming the positive electrode composite layer was formed on a 20 $\mu$m thick aluminum foil serving as a current collector foil using a roll coater to form the positive electrode composite layer on the current collector foil. The grammage of the positive electrode composite layer after drying was adjusted to 24 mg/$cm^2$. A positive electrode was obtained by roll pressing at a density of 3.1 g/$cm^3$.

[1-3-3] Evaluation cell preparation

The negative electrode was cut out to 42 mm x 52 mm and a nickel tab was attached to a copper foil. The positive electrode was cut out to 40 mm x 50 mm and an aluminum tab was attached to an aluminum foil. A polypropylene separator was laminated between the negative electrode and the positive electrode. The negative electrode composite layer and the positive electrode composite layer were laminated so as to face each other, interposing the separator. This was packed using an aluminum laminate, leaving one opening. An electrolytic solution was injected into this through the opening, and then the opening was sealed by thermal fusion bonding to obtain an evaluation cell. For the electrolytic solution, a liquid was used in which a solvent obtained by mixing ethylene carbonate, ethyl methyl carbonate, and diethyl carbonate at a volume ratio of 3:5:2 was mixed with 1 mass% of vinylene carbonate (VC), into which an electrolyte $LiPF_6$ was further dissolved to a concentration of 1 mol/L.

[1-3-4] Negative electrode composite layer thickness measurement during initial charging

A charge/discharge test was performed using the evaluation cell in a constant temperature vessel at 25°C, and the evaluation cell after charging was dismantled in a glove box in an argon atmosphere, the negative electrode was washed using ethyl methyl carbonate, then dried in vacuum at room temperature for 15 hours. The thickness after drying was measured using a micrometer and set as the electrode thickness. The difference between the thickness of the current collecting foil which was used and the electrode thickness was set as the charged electrode composite layer thickness.

In a charge/discharge test, constant current (constant current: CC) charging was performed at a current value equivalent to 0.1 C up to 4.2 V. Upon reaching 4.2 V, charging was switched to constant voltage (constant voltage: CV) charging. The cut-off condition was set as the time point at which the current value attenuated to a 0.02 C equivalent. Thereafter, the gas generated in the evaluation cell was removed and the evaluation cell was resealed. The CC discharge was performed at a current value of 0.1 C up to a lower limit voltage of 2.7 V. Next, CC charging was performed at a current value of 0.2 C with an upper limit voltage of 4.2 V, and CV charging was performed at a 0.05 C cutoff.

In the present test, a "current value equivalent to 1 C" is the magnitude of current capable of completing discharge of the capacity of the negative electrode estimated from the mass of Si and carbon (including graphite) of the negative electrode active material included in the negative electrode and the theoretical specific capacity (4,200 mAh/g and 372 mAh/g, respectively) in one hour.

[1-3-5] Expansion rate

A volume expansion rate of the electrode during charging was calculated by dividing the charged electrode thickness by the initial electrode thickness.

[1-4] BET specific surface area and pore volume (nitrogen adsorption test)

Using the Quantachrome NOVA (registered trademark) 4200e as the measuring device, the sample was placed in a sample cell (9 mm × 135 mm) to achieve a total surface area of 2 to 60 m$^2$, dried for 1 hour under vacuum conditions at 300°C, the mass of the sample was measured, and measurement was performed. Nitrogen was used as the gas for measurement.

The minimum relative pressure setting during measurement was 0.005, and the maximum relative pressure setting was 0.995. The BET specific surface area of the porous carbon material was calculated from the adsorption isotherm data below a relative pressure of 0.08 near 0.005 using the BET multi-point method. The BET specific surface area of the composite particles was calculated from the adsorption isotherm data at three points near relative pressures of 0.1, 0.2, and 0.3 using the BET multi-point method. The pore volume $V_{0.99}$ was determined by calculating the adsorption amount at a relative pressure of 0.99 using linear approximation from the adsorption isotherm data at two points around a relative pressure of 0.99, and by using the standard molar volume of nitrogen, the density of liquid nitrogen, and the atomic weight of nitrogen. The pore volume $V_{0.01}$ at a relative pressure of 0.01 was determined similarly to $V_{0.99}$ by calculating the adsorption amount at a relative pressure of 0.01 using linear approximation from the adsorption isotherm data at two points around a relative pressure of 0.01.

At this time, the density of nitrogen liquid was calculated as 0.808 (g/cm$^3$), the standard molar volume of nitrogen as 22.4133 L, and the atomic weight of nitrogen as 14.0067.

[1-5] Scanning electron microscope (Scanning Electron Microscope: SEM) and energy dispersive X-ray spectroscope (Energy Dispersive X-ray Spectroscopy: EDS)

The sample was supported on a carbon tape, and in the case of particle observation, observation was performed as is. In the case of cross-sectional observation, a cross-section of a processed product was observed using a Cross Section Polisher (registered trademark) manufactured by JEOL. Observations and measurements were performed by the following methods.

SEM: Scanning Electron Microscope Device: Regulus (registered trademark) 8220 (manufactured by Hitachi High-Tech Corporation)

EDS: XFlash (registered trademark) 5060 FlatQUAD (manufactured by Bruker Corporation) Acceleration voltage: 1 to 20 kV

Observation magnification: 500 to 5,000 times (suitably selected according to particle size)

[1-6] Particle size distribution measurement

One scoop of a very small spatula of the sample and two drops of a 100-fold diluted solution of a non-ionic surfactant (SARAYA Co., Ltd., Coconut Detergent High Power) at 32 mass% were added to 15 mL of water, and this was ultrasonically dispersed for 3 minutes. The following method was used to measure this dispersion.

Device: Seishin Enterprise's laser diffraction particle size distribution measuring instrument (LMS-2000e)

Analysis: The volume-based cumulative particle diameter distribution was calculated, and the 10% particle diameter $D_{V10}$ ($\mu$m), 50% particle diameter $D_{V50}$ ($\mu$m), and 90% particle diameter $D_{V90}$ ($\mu$m) were determined.

[Example 1]

[Resin Synthesis]

(Synthesis of Porous Hollow Particle Resin)

In a 1 L flask to which a cooling tube, a stirring device, and a dropping funnel were connected, 112 g of 36 mass% aqueous Arabic Gum (reagent manufactured by Fujifilm Wako Pure Chemical), 11.8 g of 40 mass% aqueous Triethanol Lauryl Sulfate (reagent manufactured by Fujifilm Wako Pure Chemical), 0.45 g of 74.1 mass% aqueous Tetrakis(hydroxymethyl)phosphonium Sulfate (reagent manufactured by Tokyo Chemical), and 190.5 g of phenol (reagent manufactured by Kanto Chemical), which had been melted, in advance were loaded and stirred. Thereafter, stirring did not stop until the end of the reaction.

The reaction solution was heated to 60°C and stirred for 30 minutes, added 10.8 g of Triethylamine (reagent manufactured by Kanto Chemical). 292.6 g of 37 mass% aqueous formaldehyde solution (Kanto Chemical reagent) was added over 2 minutes. The temperature of the reaction solution was raised to the reflux temperature.

Two hours after starting reflux, 9.0 g of triethylamine (Kanto Chemical reagent) was added. Three hours and 30 minutes after starting reflux, 5.4 g of triethylamine (Kanto Chemical reagent) was added.

Four hours and 30 minutes after starting reflux, 200 g of water was added and the reaction solution was cooled to 90°C. 1.8 g of sulfuric acid (Kanto Chemical reagent) was added and stirring was continued for 30 minutes. The reaction solution was cooled to 40°C or lower to complete the reaction.

Approximately 200 mL of water was added to the reaction solution, to make a total of 1L, and centrifuged at 6,000 rpm for 5 minutes using a high-speed cooling centrifuge (CR21-N, himac Eppendorf Group). After a 300 mL supernatant portion was removed, 300 mL of water was added and this was centrifuged at 6,000 rpm for 5 minutes. A 400 mL supernatant portion was removed.

The remaining sediment portion was spread in a tray and dried at 120°C for 18 hours using a WFO-400 hot air dryer. 50 g of the dried material was crushed for 30 seconds with a Wonder Blender (WB-1, imported, distributor: Osaka Chemical Co., Ltd.) to obtain a dry resin.

[Carbonization]

85 g of the obtained dry resin was loaded into a tubular furnace and carbonized in a nitrogen atmosphere at 900°C for 1 hour. The obtained product was crushed for 30 seconds using a Wonder Blender (WB-1, imported, distributor: Osaka Chemical Co., Ltd.), sieved through a 45 $\mu$m-opening sieve, and coarse particles removed to obtain a carbide. The obtained carbide had: BET specific surface area = 441 $m^2/g$, $V_{0.99}$ = 0.23 $cm^3/g$, $D_{V10}$ = 16 $\mu$m, $D_{V50}$ = 25 $\mu$m, $D_{V90}$ = 39 $\mu$m.

[Activation]

10 g of the obtained carbide was loaded into a tubular furnace and activated using carbon dioxide as the activation gas at 900°C for 4.4 hours. The obtained activated product was crushed for 30 seconds using a Wonder Blender (WB-1, imported, distributor: Osaka Chemical Co., Ltd.), sieved through a 45 $\mu$m-opening sieve, and coarse particles removed to obtain a porous carbon. The obtained porous carbon had: BET specific surface area = 1,746 $m^2/g$, $V_{0.99}$ = 0.93 $cm^3/g$, $V_{0.01}/V_{0.99}$ = 0.58, $D_{V10}$ = 16 $\mu$m, $D_{V50}$ = 25 $\mu$m, $D_{V90}$ = 39 $\mu$m.

[Silicon precipitation + coat layer formation]

4 g of the porous carbon was loaded into a tube furnace and reacted with silane gas at 400°C. Following replacement with an argon atmosphere, the temperature was lowered to 350°C and ethylene gas was reacted. Following replacement with an argon atmosphere, the temperature was lowered to 70°C and 10% oxygen/argon gas was reacted. This was cooled to room temperature and extracted to obtain the composite particles. The obtained composite particles had: $D_{V10}$ = 18 $\mu$m, $D_{V50}$ = 27 $\mu$m, and $D_{V90}$ = 39 $\mu$m.

[Comparative Example 1]

[Resin Synthesis]

(Synthesis of Filled Resin)

106.0 g of pre-melted phenol (Kanto Chemical Co., Inc.), 76.0 g of polyvinyl alcohol (GM-14R (18 mass% solid content aqueous solution), Mitsubishi Chemical Corporation), and 185 g of water were added in a 1 L flask connected to a dropping funnel which is equipped with a cooling tube and stirrer, and stirred at 50°C, 150 rpm. Additionally, 0.272 g of 74.1 mass% tetrahydroxymethyl phosphonium sulfate aqueous solution (THPS, Tokyo Chemical Industry Co., Ltd.) was added to the raw material phenol, and while stirring at 50°C, 6.0 g of triethylamine (Kanto Chemical Co., Inc.) was added. Then, 162.7 g of 37 mass% formaldehyde aqueous solution (Kanto Chemical Co., Inc.) was added over approximately 2 minutes, and the reaction solution was heated to reflux temperature.

Two hours after starting reflux, 5.0 g of triethylamine (Kanto Chemical reagent) was added. Three hours and 30 minutes after starting reflux, 3.0 g of triethylamine (Kanto Chemical reagent) was added.

Approximately 200 mL of water was added to the reaction solution, to make a total of 1L, and centrifuged at 6,000 rpm for 5 minutes using a high-speed cooling centrifuge (CR21-N, himac Eppendorf Group). A 300 mL supernatant portion was removed. 300 mL of water was added and this was and centrifuged at 6,000 rpm for 5 minutes. A 400 mL supernatant portion was removed.

The remaining sediment portion was spread in a tray and dried at 120°C for 18 hours using a hot air dryer WFO-400. 50 g of the dried material was crushed for 30 seconds with a Wonder Blender (WB-1, imported, distributor: Osaka Chemical Co., Ltd.) to obtain a dry resin.

[Carbonization]

90 g of the obtained dry resin was loaded in the tube furnace and subjected to the same treatment as in Example 1 to obtain a carbide. The obtained carbide had: BET specific surface area = 544 $m^2$/g, $V_{0.99}$ = 0.25 $cm^3$/g, $D_{V10}$ = 12 $\mu$m, $D_{V50}$ = 20 $\mu$m, $D_{V90}$ = 33 $\mu$m.

[Activation]

10 g of the obtained carbide was loaded into a tubular furnace, activated using carbon dioxide as the activation gas at 950°C for 2.9 hours, and cooled to room temperature to obtain a porous carbon. The obtained porous carbon had: BET specific surface area = 2,132 $m^2$/g, $V_{0.99}$ = 0.96 $cm^3$/g, $V_{0.01}/V_{0.99}$ = 0.63, $D_{V10}$ = 12 $\mu$m, $D_{V50}$ = 21 $\mu$m, $D_{V90}$ = 34 $\mu$m.

[Silicon precipitation + coat layer formation]

The same treatment as in Example 1 was carried out to obtain composite particles. The obtained composite particles had: $D_{V10}$ = 14 $\mu$m, $D_{V50}$ = 23 $\mu$m, and $D_{V90}$ = 36 $\mu$m.

[Table 1]

| | Effect | | | Structure | | |
|---|---|---|---|---|---|---|
| | Initial electrode composite layer thickness ($\mu$m) | Charged electrode composite layer thickness during initial charging ($\mu$m) | Expansion rate (%) | He true density (g/cm$^3$) | 1-Butanol true density (g/cm$^3$) | Cross-sectional SEM observation |
| Example 1 | 84 | 139 | 165 | 1.9 | 1.43 | Cavity-containing hollow structure (many cavities) |
| Comparative example 1 | 82 | 145 | 176 | 1.9 | 1.68 | Filled structure |

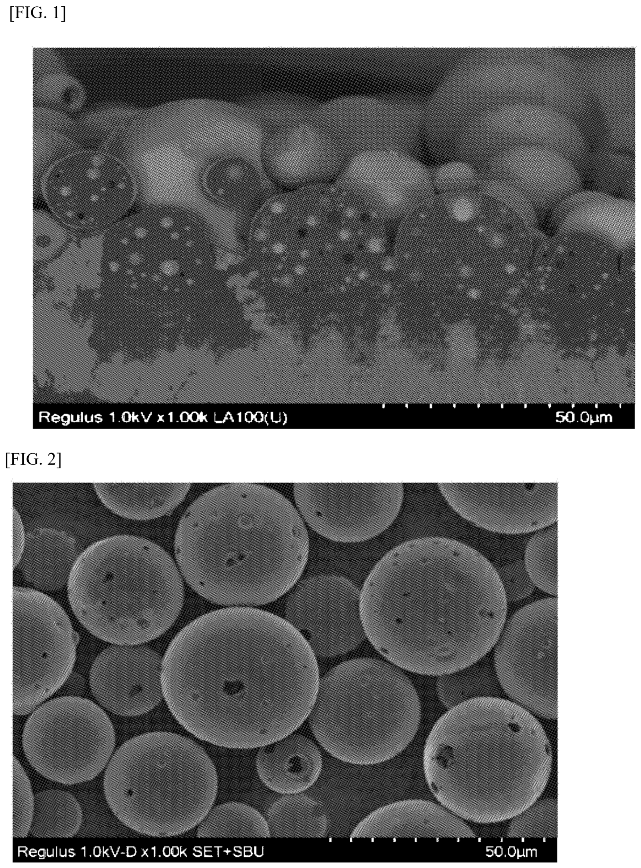

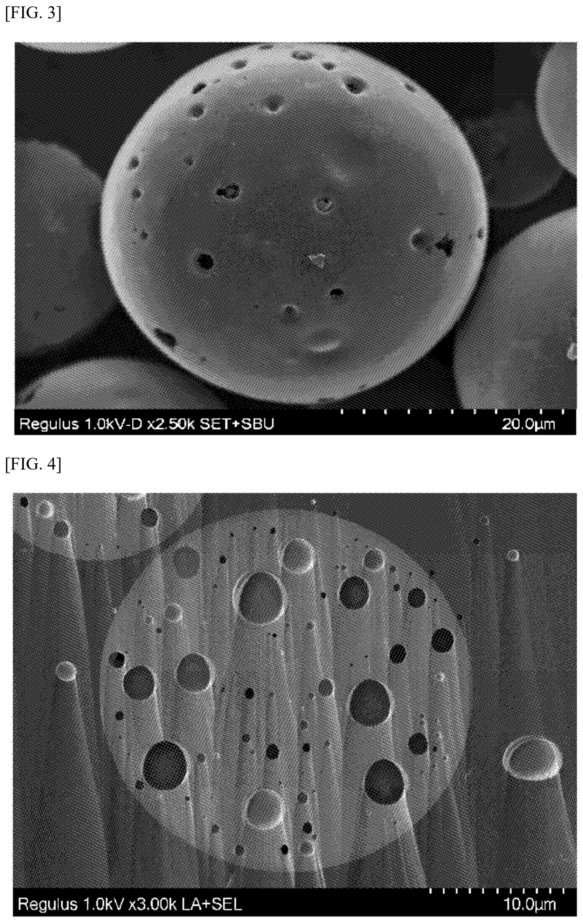

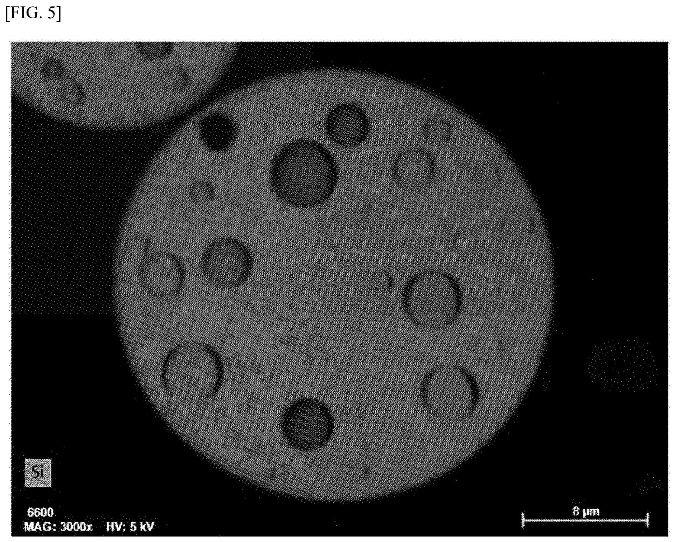

The composite particles produced in Example 1 may be determined to have a hollow structure based on the measurement results of the He true density and BA true density. Moreover, it can be seen from FIGS. 1 to 5 that the composite particles have many cavities of 0.2 $\mu$m to 20 $\mu$m inside. Moreover, it can be seen from FIG. 5 that the Si domain is uniformly present inside the composite particles.

In the composite particles of Example 1, the expansion rate of the electrode during charging was reduced by 10% or more compared to the composite particles of Comparative Example 1.

**INDUSTRIAL APPLICABILITY**

The composite particles of the present invention can be suitably used as negative electrode active materials constituting the negative electrode composite layer of lithium-ion rechargeable batteries, for example. The lithium-ion rechargeable battery of the present invention can be suitably used as a power source for electronic devices such as smartphones, mobile phone terminals, and tablet PCs, as well as for power sources of electric motors such as those for vacuum cleaners, power tools, electric bicycles, drones, and electric vehicles, and for storing electricity obtained from fuel cells, solar power generation, and wind power generation.

**Claims**

1. Composite particles comprising a carbon material and silicon, wherein:

a He true density, which is the true density by dry density measurement using helium gas, is 1.30 $g/cm^3$ or more and 2.10 $g/cm^3$ or less,
a BA true density, which is the true density by wet density measurement using 1-butanol, is 1.00 $g/cm^3$ or more and 1.64 $g/cm^3$ or less, and
the He true density is greater than the BA true density.

2. The composite particles according to claim 1, further comprising cavities having a diameter of 0.2 $\mu$m or more and 20 $\mu$m or less as observed in a cross-section thereof.

3. The composite particles according to claim 1, wherein a peak exists in the Raman spectrum between 450 $cm^{-1}$ and 495 $cm^{-1}$.

4. The composite particles according to claim 3, wherein
the intensity of the peak is denoted $I_{Si}$ and the intensity of the G band (peak intensity close to 1,580 $cm^{-1}$) is denoted $I_G$, and $I_{Si}/I_G$ is 1.3 or less.

5. The composite particles according to claim 4, wherein the intensity of the D band (peak intensity close to 1,350 $cm^{-1}$) is denoted $I_D$, and $I_D/I_G$ is between 0.2 and 1.4.

6. The composite particles according to claim 1, wherein the carbon material is porous carbon, and silicon is present in the pores of the porous carbon.

7. The composite particles according to claim 1, wherein a silicon content is 30 mass% or more and 80 mass% or less, and an oxygen content is 4.0 mass% or less.

8. The composite particles according to claim 1, wherein (peak intensity of SiC (111) surface)/(peak intensity of Si (111) surface) is 0.01 or less in an XRD pattern by powder XRD using Cu-K$\alpha$ radiation.

9. The composite particles according to claim 1, wherein the 50% particle diameter $D_{V50}$ in the volume-based cumulative particle size distribution is between 1.0 $\mu$m and 40.0 $\mu$m, and the 90% diameter $D_{V90}$ is 50.0 $\mu$m or less.

10. The composite particles according to claim 1, wherein the BET specific surface area is 0.5 $m^2/g$ or more and 30.0 $m^2/g$ or less.

11. The composite particles according to claim 1, wherein the atomic ratios of Si, O, and C obtained from the narrow spectra of X-ray photoelectron spectroscopy are denoted $A_{Si}$, $A_O$, and $A_C$, respectively, and the ratios of Si type from Si 2p spectrum analysis, $SiO_2$ and SiO are denoted $B_{SiO2}$ and $B_{SiO}$, respectively, $A_{Si}$ is 0.05 or more, and $A_C/(A_C + A_{Si} \times (B_{SiO2} + B_{SiO}))$ is 0.55 or more.

12. A method for producing composite particles, comprising a step (A) for bringing a gas including a silicon-containing gas into contact with a porous carbon satisfying the following conditions at 300°C or more and 500°C or less to precipitate silicon in the pores of the porous carbon.
Conditions: Cavities having a diameter of 0.2 $\mu$m or more and 20 $\mu$m or less as observed in a cross-section thereof are included and, in a nitrogen gas absorption test, when the pore volume when a relative pressure $P/P_0$ is 0.01 is denoted $V_{0.01}$, and a pore volume when the relative pressure $P/P_0$ is 0.99 is denoted $V_{0.99}$, $V_{0.99}$ is 0.4 $cm^3/g$ or more and 1.5 $cm^3/g$ or less, and $V_{0.01}/V_{0.99}$ is 0.4 or more.

13. The method for producing composite particles according to claim 12, further comprising a step (B) for bringing a gas including a hydrocarbon having an unsaturated bond into contact with the particles obtained in the step (A) at 500°C or lower.

14. The method for producing composite particles according to claim 12, further comprising a step (C) for oxidizing the particles obtained in the step (A).

**15.** The method for producing composite particles according to claim 13, further comprising a step (C) for oxidizing the particles obtained in the step (B).

**16.** The method for producing composite particles according to claim 12, wherein the composite particles according to claim 1 are produced.

**17.** A negative electrode active material comprising the composite particles according to claim 1.

**18.** The negative electrode composite layer comprising the negative electrode active material according to claim 17.

**19.** A lithium-ion rechargeable battery comprising the negative electrode composite layer according to claim 18.

[FIG. 1]

[FIG. 2]

[FIG. 3]

Regulus 1.0kV-D x2.50k SET+SBU          20.0μm

[FIG. 4]

Regulus 1.0kV x3.00k LA+SEL          10.0μm

[FIG. 5]

## INTERNATIONAL SEARCH REPORT

| International application No. |
|---|
| **PCT/JP2023/041101** |

| A. | CLASSIFICATION OF SUBJECT MATTER |
|---|---|

*H01M 4/38*(2006.01)i; *C01B 32/05*(2017.01)i; *C01B 33/029*(2006.01)i; *H01M 4/36*(2006.01)i
FI:   H01M4/38 Z; C01B32/05; C01B33/029; H01M4/36 A

According to International Patent Classification (IPC) or to both national classification and IPC

| B. | FIELDS SEARCHED |
|---|---|

Minimum documentation searched (classification system followed by classification symbols)

H01M4/38; C01B32/05; C01B33/029; H01M4/36

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2018-534720 A (ENERG2 TECHNOLOGIES, INC.) 22 November 2018 (2018-11-22) | 1-19 |
| A | JP 2020-514231 A (GROUP 14 TECHNOLOGIES, INC.) 21 May 2020 (2020-05-21) | 1-19 |
| A | WO 2021/241754 A1 (SHOWA DENKO K.K.) 02 December 2021 (2021-12-02) | 1-19 |
| A | JP 2016-132608 A (KABUSHIKI KAISHA TOYOTA CHUO KENKYUSHO) 25 July 2016 (2016-07-25) | 1-19 |
| A | JP 2009-200014 A (SUMITOMO BAKELITE CO., LTD.) 03 September 2009 (2009-09-03) | 1-19 |
| P, A | WO 2022/270539 A1 (SHOWA DENKO K.K.) 29 December 2022 (2022-12-29) | 1-19 |

☐ Further documents are listed in the continuation of Box C.          ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 January 2024** | **06 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2023/041101**

| Patent document cited in search report | | | Publication date (day/month/year) | Patent family member(s) | | | Publication date (day/month/year) |
|---|---|---|---|---|---|---|---|
| JP | 2018-534720 | A | 22 November 2018 | JP | 2022-153561 | A | |
| | | | | US | 2017/0170477 | A1 | |
| | | | | US | 2019/0280298 | A1 | |
| | | | | US | 2020/0075954 | A1 | |
| | | | | US | 2020/0365896 | A1 | |
| | | | | US | 2020/0152983 | A1 | |
| | | | | US | 2022/0231296 | A1 | |
| | | | | US | 2022/0352517 | A1 | |
| | | | | US | 2023/0058348 | A1 | |
| | | | | WO | 2017/040299 | A1 | |
| | | | | EP | 3836261 | A1 | |
| | | | | CN | 108475779 | A | |
| | | | | KR | 10-2018-0113187 | A | |
| | | | | CN | 113224274 | A | |
| | | | | KR | 10-2023-0091915 | A | |
| | | | | KR | 10-2023-0092015 | A | |
| JP | 2020-514231 | A | 21 May 2020 | US | 2020/0020935 | A1 | |
| | | | | WO | 2018/165610 | A1 | |
| | | | | KR | 10-2019-0122805 | A | |
| | | | | CN | 110582823 | A | |
| WO | 2021/241754 | A1 | 02 December 2021 | JP | 2021-187733 | A | |
| | | | | US | 2023/0223537 | A1 | |
| | | | | US | 2023/0207780 | A1 | |
| | | | | US | 2023/0216025 | A1 | |
| | | | | US | 2023/0231111 | A1 | |
| | | | | WO | 2021/241747 | A1 | |
| | | | | WO | 2021/241748 | A1 | |
| | | | | WO | 2021/241749 | A1 | |
| | | | | WO | 2021/241750 | A1 | |
| | | | | EP | 4160726 | A1 | |
| | | | | EP | 4159681 | A1 | |
| | | | | EP | 4160727 | A1 | |
| | | | | EP | 4160728 | A1 | |
| | | | | CN | 115668545 | A | |
| | | | | KR | 10-2023-0017259 | A | |
| | | | | CN | 115667136 | A | |
| | | | | CN | 115668539 | A | |
| | | | | CN | 115699368 | A | |
| | | | | KR | 10-2023-0015992 | A | |
| | | | | KR | 10-2023-0016213 | A | |
| | | | | KR | 10-2023-0016214 | A | |
| JP | 2016-132608 | A | 25 July 2016 | (Family: none) | | | |
| JP | 2009-200014 | A | 03 September 2009 | (Family: none) | | | |
| WO | 2022/270539 | A1 | 29 December 2022 | (Family: none) | | | |

Form PCT/ISA/210 (patent family annex) (July 2022)

**EP 4 645 465 A1**

**REFERENCES CITED IN THE DESCRIPTION**

**Patent documents cited in the description**

- JP 2018534720 W